# EUROPÄISCHE PATENTSCHRIFT

(11) **EP 2 843 322 B1**
(45) Veröffentlichungstag und Bekanntmachung des Hinweises auf die Patenterteilung: **30.01.2019**
(21) Anmeldenummer: 14172952.5
(22) Anmeldetag: 18.06.2014
(51) Int. Cl.: F24S 30/425, H01L 31/052, F24S 25/10, F24S 30/00

(54) **Vorrichtung für Halterung und Sonnenstandsnachführung von Nachführeinheiten für Solarpanele**
Device for the support and sun tracking of tracking units for solar panels
Dispositif de support et de suivi de la position du soleil d'unités de poursuite pour panneaux solaires

(30) Priorität: 24.07.2013 AT 5010413 U
(43) Veröffentlichungstag der Anmeldung: 04.03.2015
(73) Patentinhaber: Fischer, Werner, 94107 Untergriesbach (DE)
(72) Erfinder: Fischer, Werner, 94107 Untergriesbach (DE)
(74) Vertreter: Babeluk, Michael

(56) Entgegenhaltungen:
- EP-A1- 2 123 993
- EP-A2- 2 735 817
- WO-A2-2012/152344
- DE-U1-202011 103 199
- US-A1- 2010 071 683
- US-A1- 2012 180 845
- US-A1- 2013 340 807

## Beschreibung

### Technisches Gebiet

Die vorliegende Erfindung betrifft eine Vorrichtung für die Halterung und einachsige Sonnenstandsnachführung von mehreren hintereinander angeordneten Nachführeinheiten für Solarpanele mit Antriebseinheiten für diese Sonnenstandsnachführung, wobei jede Nachführeinheit ein Tragegerüst für zwei nebeneinander angeordnete Solartische mit jeweils mehreren Solarpanelen, die auf Panelträgern montiert sind, je eine zugehörige Hauptträgerwelle und eine Antriebseinheit aufweist, wobei jede Hauptträgerwelle endständig mit je einer Hauptträgeraufnahme verbunden ist, wobei die in Reihe angeordneten Hauptträgerwellen und Hauptträgeraufnahmen eine Drehachse der Vorrichtung bilden, wobei mindestens eine Antriebseinheit vorgesehen ist, die mit zwei unmittelbar nebeneinander liegenden Hauptträgeraufnahmen gekoppelt ist, so dass eine Antriebseinheit mit jeweils zwei Hauptträgerwellen kommuniziert und durch Ein- oder Ausfahren eines Teleskoparms die Nachführung beider Solartische von Ost nach West und zurück bewirkt, und wobei benachbarte Hauptträgeraufnahmen über jeweils ein Halteteil an einem gemeinsamen Rammprofil gestützt sind und die Antriebseinheit mit dem Rammprofil und den beiden Halteteilen verbunden ist.

### Stand der Technik

Vorrichtungen zur Sonnenstandsnachführung für Energieumwandlungsmodule sind seit geraumer Zeit bekannt. So beschreibt die Deutsche Gebrauchsmusteranmeldung DE 20 2009 006 082 ein System der gattungsgemäßen Art, wobei eine Mehrzahl von Nachführeinheiten mindestens eine Koppelstange und mindestens eine Antriebseinheit besitzen, wobei jede Nachführeinheit ein Traggestell zum Aufnehmen mindestens eines Energieumwandlers und zwei zueinander beabstandete Stützelemente umfasst, zwischen denen das Traggestell um eine Drehachse drehbar gelagert ist. Das Traggestell besitzt einen Hebel, der mit der Koppelstange verbunden ist. Über eine Bewegung der Koppelstange quer zu den Schwenkachsen der Traggestelle sind diese gemeinsam verschwenkbar. Analoge Einrichtungen gehen auch aus der WO 2006/020597 und der US 6,058,930 hervor. Ziel der DE 20 2009 006 082 gegenüber den letztgenannten Veröffentlichungen ist es, einen einfacheren Aufbau der Energieumwandlungsanlage mit mehreren Energieumwandlungsmodulen und mehreren Nachführeinheiten zu schaffen. Dies wird erreicht, indem die Stützelemente als Rammprofile ausgebildet sind, welche für die Aufstellung in unebenem Gelände geeignet sind, um die gewünschte Nord-Süd-Neigung der Anlage zu ermöglichen. Nachteilig bei der Lösung der Aufgabe nach der DE 20 2009 006 082 ist allerdings, dass die Lagerung der Drehwelle starr ist, d.h. die Drehwelle selbst muss absolut geradlinig entlang der Nord-Süd-Neigung ausgebildet sein.

Ein weiteres System der gattungsgemäßen Art wird durch die DE 20 2011 101 252 geoffenbart. Bei dieser Vorrichtung zum Zusammenbau einer terrestrischen Solar-fotovoltaischen Nachführanordnung besteht das Drehmomentrohr aus mehreren nacheinander auf vertikalen Traggliedern montierten Drehmomentrohren. Ziel dieser Erfindung ist es, den Zusammenbau der Anlage an Ort und Stelle durch wenig ausgebildete Arbeiter zu ermöglichen. Nachteilig bei diesem System ist jedoch die Halterung der einzelnen Abschnitte des Drehmomentrohres, welche miteinander in kollinearer Art mit Ende-an-Ende-Orientierung an beabstandeten Vertikalträgern angebracht sind, da sie ebenfalls einen vollkommen geradlinigen Verlauf der einzelnen Abschnitte des Drehmomentrohres vorsehen, eine Knickung der Drehachse des Drehmomentrohres vertikal zur Drehachse, welche bei unebenem Gelände bisweilen erforderlich ist, um umfangreichere Erdarbeiten zur Vorbereitung des Aufstellungsuntergrundes zu vermeiden, ist bei dem System nach DE 20 2011 101 252 nicht möglich.

Aus dem Stand der Technik sind weiteres zahlreiche Antriebseinheiten zur Drehung einer geradlinigen Trägerwelle zur Halterung einer Mehrzahl von Solarpanelen oder Solarpanelfeldhalterungen bekannt, exemplarisch wird auf die DE 20 2011 103 199, die EP 2 123 993 A1 und die US 2012/0216852 A1 verwiesen, welche jedoch ausschließlich bei ebenen Aufstellungsorten zur Anwendung kommen können.

Beim gattungsgemäßen Wellenlager für Solarpanele und Antriebseinheit gemäß der EP 2 123 933 A1 sind benachbarte Hauptträgerwellen 3 durch Zwischenachsen 4 verbunden, wobei die Verbindung der Zwischenachse 4 mit benachbarten Hauptträgerwellen 3 starr ist und keinen Freiheitsgrad in Bezug auf geringfügige Winkelabweichungen bei unebenem Geländeverlauf ermöglichen.

Die WO2012/152344 A2, US2010/0071683 A1, EP2735817 A2 und US2012/0180845 A1 offenbaren auch solche Vorrichtungen.

### Technische Aufgabenstellung

Die Verwendung von Rammprofilen als Stützelemente hat sich als wirtschaftlich sehr vorteilhaft herausgestellt, da hier eine weitgehende Erhaltung des Mutterbodens in seiner ursprünglichen Gestalt möglich ist, welche für die Gesamtstatik der Vorrichtung große Bedeutung hat. Ein üblicher Geländeverlauf entspricht jedoch nicht diesem Idealfall eines absolut ebenen Mutterbodens. Meist sind Unebenheiten vorhanden auf welche bei der Montage der Rammprofile besonders Bedacht zu nehmen ist, d.h. die Montage der Rammprofile gestaltet sich sehr zeitaufwändig. Trotz aller Sorgfalt ist es jedoch kaum möglich, alle Auflageflächen einer durchgehenden Drehachse 100 %ig eben zueinander auszurichten.

Die vorliegende Erfindung stellt sich daher die Aufgabe bei einer Antriebseinheit, die sich ähnlich wie die Antriebseinheit, welche in der EP 2 123 993 A1 offenbart wird, auf einem Rammprofil abstützt und mit ihrer Antriebsstange unmittelbar an einer Drehachse angreift, einen optimalen Lastverlauf während der Schwenkbewegung zu ermöglichen.

### Allgemeine Darstellung der Erfindung

Diese Aufgabe wird ausgehend von einer Vorrichtung der eingangs genannten Gattung gelöst, erfindungsgemäß dadurch gelöst, dass die Hauptträgeraufnahme mit Bolzen versehen ist, die in Ausnehmungen von sich gegenüberliegenden Seitenwänden eines mit dem Rammprofil verbundenen Lagerwellenträgers mit Spiel gelagert sind, derart, dass die benachbarten Hauptträgeraufnahmen in Neigung zur Drehachse verbringbar sind.

Im Unterschied zu der Antriebseinheit gemäß der eingangs genannten Gattung ist die erfindungsgemäße Einheit geeignet, einen optimalen Lastverlauf während einer Schwenkbewegung einzuhalten, indem benachbarte Drehachsen einer mehrteiligen Gesamtdrehachse gegebenenfalls geknickt - also in einem geneigten Winkel zueinander - eingestellt werden können.

Die Drehachse ist somit mehrteilig ausgebildet und kann gegebenenfalls dem Geländeverlauf entsprechend in der Längsachse geknickt verlaufen. Dabei können benachbarte Drehachsenabschnitte, die auf einem gemeinsamen Rammprofil aufliegen, in einem begrenzten Umfang einen nichtlinearen Verlauf haben, um die Gesamtanlage bei Geländeunebenheiten dem Geländeverlauf entsprechend anordnen zu können. Damit soll verhindert werden, dass der Mutterboden durch umfangreiche Erdarbeiten belastet wird, welche die Statik der Gesamtanlage negativ beeinflussen könnte.

Dies wird zum einen dadurch erreicht, dass die Hauptträgeraufnahme mit Bolzen in Ausnehmungen von sich gegenüberliegenden Seitenwänden des Lagerwellenträgers gelagert sind, und zum anderen dadurch, dass diese Lagerung soviel Spiel hat, dass sich ohne zusätzlichen Kraftaufwand durch Dreh- und Kippbewegungen ein Winkel ungleich Null (beziehungsweise ungleich 180 Winkelgrad) zwischen den Drehachsenabschnitten einstellt. Das Spiel wird beispielsweise dadurch erreicht, dass die Bolzen in Aufnahmen ohne Presspassung einliegen.

Die Hauptträgerwelle, welche die Stützelemente einer Mehrzahl von Solarpanelen trägt, liegt endseitig jeweils in einer Hauptträgeraufnahme auf, und die Hauptträgeraufnahme wird wiederum mittels Bolzen in einem Lagerwellenträger gehalten, wobei der Stützschaft des Lagerwellenträgers im oberen Ende des Rammprofils eingeführt ist.

Die Hauptträgeraufnahme umfasst bevorzugt eine Drehwelle, eine Bolzenplatte an einem Ende der Drehwelle in welcher sich die Drehwelle ungehindert drehen kann und eine Halteplatte mit fest montierten Drehwellenlagerprofilen, einer Gegenplatte und Befestigungsbolzen, mit welchen die Gegenplatte mit der Halteplatte verbunden ist.

Die Antriebseinheit, welche am Schaft des Rammprofiles befestigt ist, greift an der Halteplatte der Drehwelle an.

Die Hauptträgerwelle liegt zwischen der Halteplatte und der Gegenplatte und ist beispielsweise über die Befestigungsbolzen zwischen der Halteplatte und der Gegenplatte klemmend fixiert. Somit besteht die Lagerung der Hauptträgeraufnahme aus einer Drehaufhängung welche Dreh und Kippbewegungen aufnimmt. Die Drehwelle ist entweder lagerlos oder alternativ mit Buchse oder sonstigem Lager ausgestattet.

Die Hohlwelle ist mit einer Grundplatte verbunden, welche zum Klemmen oder Verschrauben einer Trägerwelle dient. Alternativ soll auch eine Vollwelle mit jedem gängigen Profil verwendet werden können, sei es Rundrohr, Ovalrohr, Vierkantrohr, Dreieckrohr, H-Eisen (Stahl), T-Eisen, Winkeleisen, sonstige Profile.

Hier können vorgeformte Flacheisen mit seitlich angebrachten Bolzen, Kugeln mit Bolzen oder ohne Bolzen in vorgefertigten Auflagern verwendet werden. Die Vermeidung von Verschiebungen kann mittels aufgebrachter Begrenzungsringe, Stecksplinten, Sperrstiften, eingekerbten Führungseisen oder Anschlägen hergestellt werden.

Die Drehwelle ist auf einer Halteplatte befestigt und wird mit statisch notwendigen Verstärkungen so mit der Grundplatte verbunden, dass die Torsionskräfte zur Lenkung der angetrieben Welle aufgenommen werden ohne Verwindung der Drehwelle. Die Halteplatte ist idealerweise aus einem Stück gefertigt, kann aber auch in Einzelstücken mit der Drehwelle verbunden werden.

Ein Teil der Halteplatte wird mittels Gegenplatte zum formfesten Verklemmen der Hauptträgerwelle mit der angetrieben Hauptträgeraufnahme verwendet. Ein Teil der Halteplatte oder der gesondert angebrachte Teil der Halteplatte wird zur Befestigung des Antriebsbügels verwendet. Die Befestigung des Antriebsbügels kann mittels Verschraubung oder auch durch Stecken in vorgefertigte Steckhülsen erfolgen. Bei verschraubter Ausführung werden innerhalb des Bügels vorgebohrte Beilegplatten, Beilegscheiben oder grundsätzlich stärkere Wandstärken des Antriebsbügels nach statischer Notwendigkeit verwendet.

Der Antriebsbügel, welcher zwei Hauptträgeraufnahmen schlüssig miteinander verbindet, so dass zwei Wellen gleichzeitig und im Gleichlauf angetrieben werden können, ist in Vierkantrohr alternativ in Rundrohr, Ovalrohr, Dreiecksprofil, T-Eisen, H-Eisen U-Eisen ausgeführt. Die Form des Antriebsbügels ist wahlweise zweieckig, eineckig, gerundet, geschweißt oder gebogen.

Mit den vorbeschriebenen Antriebsbügeln können auch mehrere Wellen hintereinander angetrieben werden. Ausdrücklich wird auf die Möglichkeit verwiesen, dass diese Bügel auch zu beiden Seiten der Pfosten angebracht werden können, so dass über höhere Stabilität der Verschraubung und der Verwendung von geeigneten Motoren auch mehr als zwei Wellen miteinander verbunden und angetrieben werden können. Als Antriebseinheiten dienen Linearmotoren, hydraulische Antriebe, Seilzüge, Kettenantriebe oder Schubstangen.

Die Bolzenplatte liegt mit einer Schmalseite dergestalt im Lagerwellenträger, dass die seitlich abstehenden Bolzen durch zwei gegenüberliegende U-förmige Ausnehmungen in der Seitenwand des Lagerwellenträgers ragen. Ein aufgesetztes Kammblech hält die Bolzen in den U-förmigen Ausnehmungen und verhindert, deren Austreten nach oben, sobald die Drehwelle gedreht wird. In den U-förmigen Ausnehmungen der Seitenwände des Lagerwellenträgers finden die Bolzen ein geringfügiges Spiel. Die vertikal von der Drehwelle abstehenden Teile der Bolzenplatte sind in einer bevorzugten Ausführung unterschiedlich hoch ausgeführt, womit eine bessere Anpassung der Höhenlage der Drehwelle zur Erzielung der gewünschten Neigung der Hauptträgerwelle zur Anpassung an einen unebenen Geländeverlauf ermöglicht ist.

Ein Linearantrieb ist am Schaft des Rammprofiles befestigt. Die Halteplatte des Linearantriebs besitzt auf einer Seite fest montierte Profile, welche die Kontur des Rammprofiles teilweise umfassen, und auf der gegenüber liegenden Seite fest montierte Backen zwischen welchen das untere Auge des Linearantriebs gelagert ist.

Das obere Auge des Linearantriebs ist mit einem Antriebsbügel verbunden. Der Antriebsbügel besteht beispielsweise aus drei, bevorzugt aus fünf miteinander fest verbundenen Abschnitten, die gemeinsam ein U-Profil beschreiben, wobei sich am Verbindungsarm die Backen befinden, an denen das obere Auge des Linearantriebs befestigt ist. Die endteiligen Abschnitte des Antriebsbügels sind mit der Halteplatte verbunden. Diese Ausführungsform wird in der weiteren Beschreibung und in den Figuren zur Veranschaulichung der Erfindung beibehalten. Es versteht sich jedoch von selbst, dass der Antriebsbügel auch ein Biegeteil aus einem Rohr beliebigen Querschnitts sein kann. Auch jede andere Form des Antriebsbügels, die den beschriebenen Drehvorgang in der gewünschten Weise ermöglicht, fällt unter die gegenständliche Erfindung.

Bei einer bevorzugten Ausführungsform eines Antriebsbügels, der sich aus fünf Abschnitten zusammensetzt, stehen die endteiligen Abschnitte im Winkel zur Ebene des Antriebsbügels. Dabei hat es sich als besonders vorteilhaft erwiesen, diesen Winkel auf etwa 15° zu bemessen. Weiters hat es sich als besonders vorteilhaft erwiesen, die Bemaßung der einzelnen Bauteile der Antriebseinheit so zu wählen, dass der Teleskoparm des Linearantriebs zur Achse des Rammprofiles einen Winkel von etwa 8° sowohl im eingefahrenen als auch im ausgefahrenen Zustand einnimmt, da hier der Antriebsmotor in jeder Stellung des Panelfeldes die geringste Kraft zum Anfahren benötigt. Der Antriebspunkt liegt damit direkt auf der Welle, wodurch ein weitestgehend gleicher statischer Verlauf erreicht wird und die Neigung der Paneele nach beiden Seiten in der jeweiligen Endstellung gleich ist.

Mit dem erfindungsgemäßen Antriebsbügel ist es möglich zwei benachbarte Panelfelder mit nur einer Antriebseinheit zu bewegen, wobei die Biegebelastung des Rammprofiles insbesondere mit der bevorzugten Ausführung der Antriebseinheit minimal ist, da der Hauptanteil der Lastwirkung senkrecht in den Mutterboden abgeleitet wird und nur eine geringe horizontale Lastwirkung auf den Rammpfosten ausgeübt wird.

Liegt ein unebener Geländeverlauf vor, beispielsweise eine Hanglage welche einen Knick im Verlauf der Achsen zweier benachbarter Hauptträgerwellen erfordert, so wird die Antriebseinheit an benachbarten Hauptträgeraufnahmen befestigt, deren Längsachsen geradlinig verlaufen und die Hauptträgeraufnahme zweier Hauptträgerwellen, deren Achsen einen Knick zueinander haben, ist hierzu etwa um die Länge der Hauptträgerwelle verschoben angeordnet.

Durch die erfindungsgemäße Ausgestaltung der Wellenlager von mehreren benachbarten Hauptträgerwellen auf einer Mehrzahl von Rammprofilen, die voneinander beabstandet angeordnet sind und der erfindungsgemäßen Antriebseinheit wird es möglich, eine Ausrichtung von mehreren nebeneinander liegenden Panelfeldern auch über mehrere Geländeunebenheiten anzubringen, wobei auch größere Geländestufen im Gegensatz zu herkömmlichen Anlagen, welche einen geradlinigen Verlauf der Drehachse der Panelfelder erfordern, wie sie aus dem Stand der Technik bekannt sind, kein Problem mehr darstellen.

### Ausführungsbeispiel

Die Erfindung wird nachfolgend anhand der Figuren näher erläutert. Darin zeigt:
- **Figur 1**: eine perspektivische Ansicht mit einem Ausschnitt einer erfindungsgemäßen Anlage, bspw. zur Gewinnung von Solarstrom;
- **Figur 2**: eine Detailansicht aus Figur 1 mit vergrößerter Darstellung der Antriebseinheit zur Verschwenkung der Panelfelder von Ost nach West und umgekehrt;
- **Figur 3**: in Seitenansicht einen Vertikalschnitt durch die Darstellung von Figur 2;
- **Figur 4**: die Detailansicht eines Lagerwellenträgers für die Aufnahme eines Endes einer Hauptträgeraufnahme nach den Figur 1 und 2;
- **Figur 5**: die Detailansicht einer Hauptträgeraufnahme nach den Figur 1 bis 3;
- **Figur 6**: eine schematische Darstellung des Verlaufs der Drehachse mehrerer Panelfelder ohne Solarpanele über ein unebenes Gelände;
- **Figur 7**: eine perspektivische Ansicht einer alternativen Ausführungsform der erfindungsgemäßen Anlage;
- **Figur 8**: eine Detailansicht aus Figur 7 mit einer drehfesten Verbindung benachbarter Panelfelder;
- **Figur 9**: eine weitere Detailansicht aus Figur 7 mit einer vorteilhaften Variante einer Antriebseinheit.

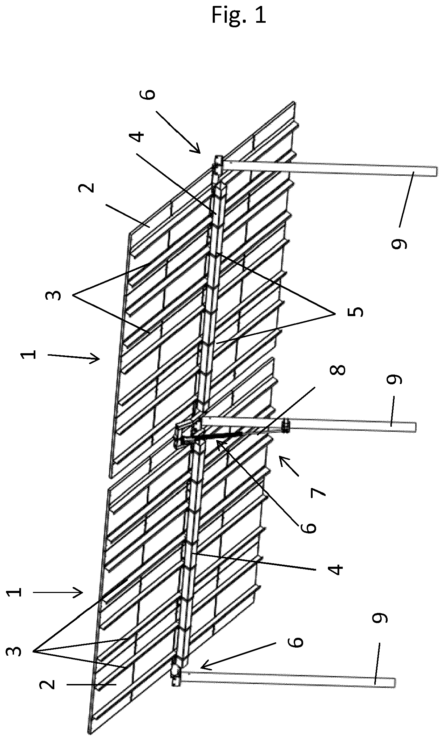

In **Figur 1** ist beispielshaft das Tragegerüst für zwei nebeneinander angeordnete Solartische 1 mit jeweils sechzehn Solarpanelen 2 zu sehen, die auf Panelträgern 3 montiert sind. Die Panelträger 3 jedes Solartisches 1 sind mit der zugehörigen Hauptträgerwelle 4 mittels Haltebügel 5 verbunden. Endständig sind die Hauptträgerwellen 4 mit Hauptträgeraufnahmen 6 verbunden. Eine Antriebseinheit 7 ist mit den beiden mittleren Hauptträgeraufnahmen 6 gekoppelt und bewirkt durch Ein- oder Ausfahren des Teleskoparms 8 die Nachführung beider Solartische 1 von Ost nach West, um die Solartische 1 dem Sonnenstand nachzuführen. Die gesamte Anordnung wird von Rammprofilen 9 gestützt.

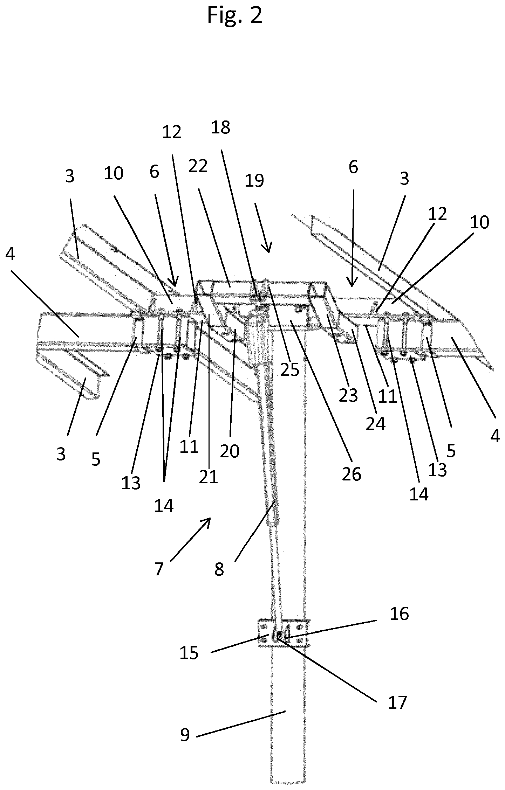

In der Detailansicht nach **Figur 2** ist die Verbindung der beiden Hauptträgerwellen 4 mit den endständigen Hauptträgeraufnahmen 6 und der Antriebseinheit 7 vergrößert dargestellt. Die Hauptträgeraufnahme 6 besteht aus einer Drehwelle 10, einer Halteplatte 11 an einem Ende der Drehwelle 10 mit fest montierten Drehwellenlagerprofilen 12, in welchen sich die Drehwelle 10 ungehindert drehen kann und aus einer Gegenplatte13 und Befestigungsbolzen 14, mit welchen die Gegenplatte 13 mit der Halteplatte 11 verbunden ist. Die Hauptträgerwelle 4 liegt zwischen der Halteplatte 11 und der Gegenplatte 13 und ist über die Befestigungsbolzen 14 zwischen der Halteplatte 11 und der Gegenplatte 13 klemmend fixiert.

Die Antriebseinheit 7 in der Form eines Linearantriebs ist am Schaft des Rammprofiles 9 befestigt und greift an der Halteplatte 11 der Drehwelle10 an. Die Halteplatte 15 des Linearantriebs besitzt auf einer Seite fest montierte Profile, welche die Kontur des Rammprofiles teilweise umfassen oder Bügel, welche den Schaft des Rammprofils 9 umfassen, und auf der gegenüber liegenden Seite fest montierte Backen 16 zwischen welchen das untere Auge 17 des Linearantriebs gelagert ist. Das obere Auge 18 des Linearantriebs ist mit einem Antriebsbügel 19 verbunden. Der Antriebsbügel 19 besteht zumindest aus drei, bevorzugt aus fünf miteinander fest verbundenen Abschnitten 20 bis 24, die gemeinsam ein U-Profil beschreiben, wobei sich am Verbindungsarm 22 die Backen 25 befinden, an denen das obere Auge 18 des Linearantriebs befestigt ist. Die endteiligen Abschnitte 20, 24 des Antriebsbügels 19 sind mit der Halteplatte11 der Drehwelle 10 verbunden.

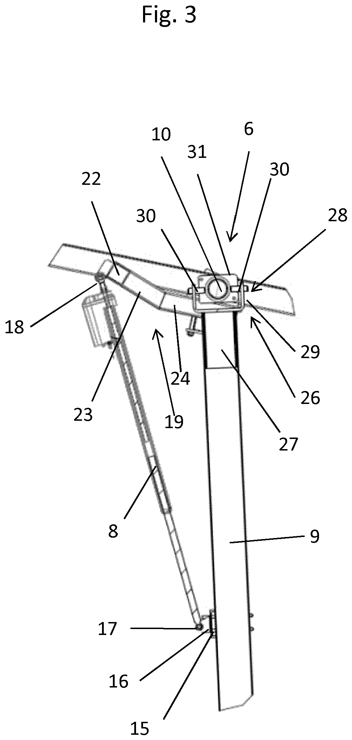

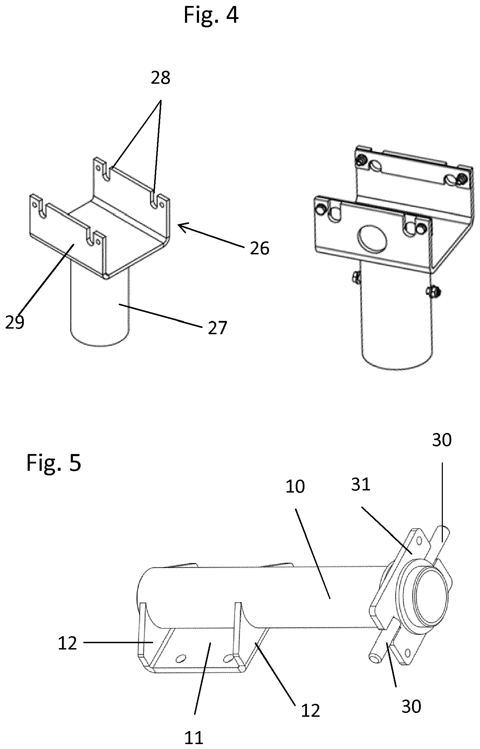

Wie aus **Figur 3** hervor geht, liegt die Hauptträgeraufnahme 6 mittels Bolzen 30 in einem Lagerwellenträger 26, wobei der Stützschaft27 des Lagerwellenträgers 26 im oberen Ende des Rammprofils 9 eingeführt ist. In **Figur 4** ist der Lagerwellenträger 26 zum besseren Verständnis nochmals separat in perspektivischer Ansicht dargestellt.

Die Halteplatte 31 liegt mit einer Schmalseite dergestalt im Lagerwellenträger 26, dass die seitlich abstehenden Bolzen 30 durch zwei gegenüberliegende U-förmige Ausnehmungen 28 in der Seitenwand 29 des Lagerwellenträgers 26 ragen. Ein hier nicht dargestelltes, aufgesetztes Kammblech hält die Bolzen 30 in den U-förmigen Ausnehmungen 28 und verhindert, deren Austreten nach oben, sobald die Drehwelle 10 gedreht wird. In den U-förmigen Ausnehmungen 28 der Seitenwände 29 des Lagerwellenträgers 26 finden die Bolzen 30 ein geringfügiges Spiel. Die vertikal von der Drehwelle 10 abstehenden Teile der Halteplatte 31 sind in einer bevorzugten Ausführung unterschiedlich hoch ausgeführt, womit eine bessere Anpassung der Höhenlage der Drehwelle 10 zur Erzielung der gewünschten Neigung der Hauptträgerwelle 4 in Anpassung an den Geländeverlauf ermöglicht ist.

Bei der in Figur 2 gezeigten, bevorzugten Ausführungsform des Antriebsbügels 19, der sich hier aus fünf Abschnitten 20 bis 24 - von denen hier lediglich die Abschnitte 22 bis 24 zu erkennen sind - zusammensetzt, stehen die endteiligen Abschnitte 20 und 24, von denen hier nur der Abschnitt 24 erkennbar ist, im Winkel zur Ebene des Antriebsbügels 19. In einer bevorzugten Ausführungsform beträgt dieser Winkel etwa 15°.

**Figur 5** zeigt zum besseren Verständnis nochmals separat in perspektivischer Ansicht die wichtigsten Bauteile der Hauptträgeraufnahme 6. Die Drehwelle 10 liegt endständig in der Halteplatte 31 und ist dort linear nicht verschiebbar, jedoch drehbar gelagert. Von der Halteplatte 31 ragen seitlich die Bolzen 30 ab. Der gegenüberliegende Abschnitt der Drehwelle 10 liegt in den Drehwellenlagerprofilen 12 der Halteplatte 11, wobei auch nur ein oder mehr als zwei Drehwellenlagerprofile 12 vorgesehen sein können. Hier nicht dargestellt ist die Gegenplatte 13, welche über Befestigungsbolzen 14 mit der Halteplatte 11 verbunden ist zur klemmenden Befestigung der Hauptträgerwelle 4.

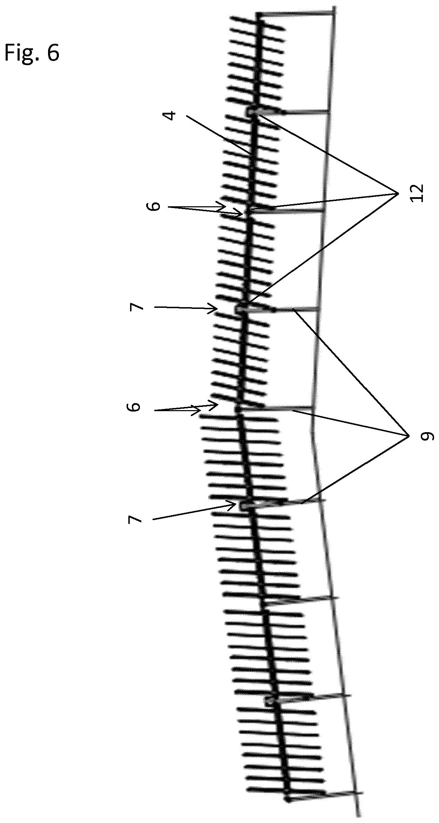

Liegt ein unebener Geländeverlauf vor, beispielsweise eine Hanglage welche einen Knick im Verlauf der Achsen zweier benachbarter Hauptträgerwellen 4 erfordert, so wird die Antriebseinheit 7 an den Halteplatten 11 von benachbarten Hauptträgeraufnahmen 6 befestigt, deren Längsachsen annähernd geradlinig verlaufen und die beiden Hauptträgeraufnahmen 6 zweier Hauptträgerwellen 4, deren Achsen einen Knick zueinander haben, ist hierzu etwa um die Länge der Hauptträgerwelle 4 verschoben angeordnet. Dargestellt ist dieser Umstand schematisch in **Figur 6****.**

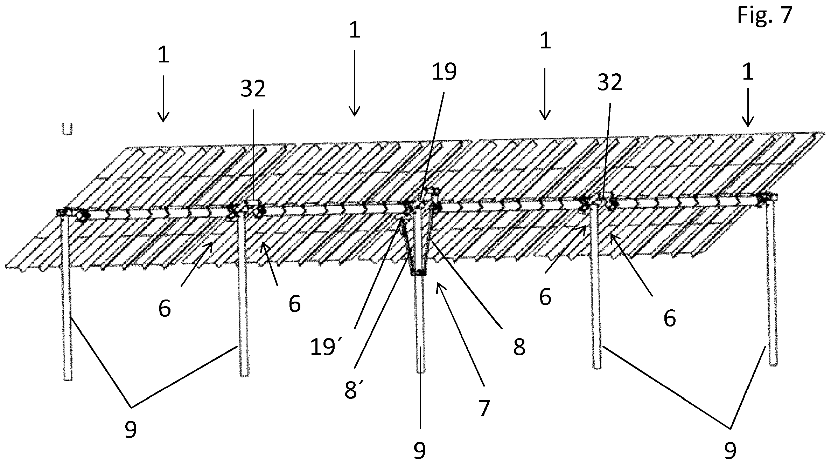

In einer bevorzugten Ausgestaltung der Erfindung setzt sich eine Nachführeinheit, welche von einem Antriebsmotor dem Sonnenstand nachgeführt wird, aus mehr als zwei Tragegerüsten für Solartische 1 zusammen. Diese Variante wird in **Figur 7** gezeigt. Hier werden exemplarisch insgesamt vier Solartische 1 durch eine Antriebseinheit 7 mit einem Motor bewegt. Je nach den örtlichen Gegebenheiten können aber auch weniger oder mehr Solartische 1 durch nur eine Antriebseinheit 7 bewegt werden. Dazu werden jene nebeneinander liegenden Hauptträgeraufnahmen 6, welche nicht über einen gemeinsamen Antriebsbügel 19 verbunden sind, über einen Halterahmen 32 drehfest miteinander verbunden.

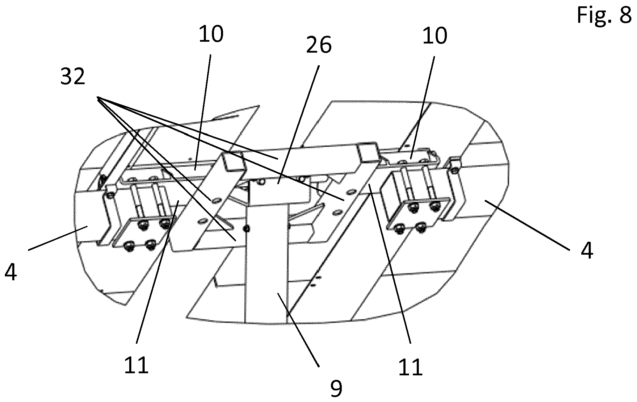

In **Figur 8** ist diese drehfeste Verbindung als vergrößerter Ausschnitt aus Figur 7 zur besseren Veranschaulichung dargestellt. Die beiden Hauptträgerwellen 4 sind endständig mit den Halteplatten 11 fest verbunden. Die Drehwellen 10 sind endständig über die Bolzen 30 im Lagerwellenträger 26 gelagert, der sich im Rammprofil 9 abstützt. Der starre Halterahmen 32 ist mit den beiden benachbarten Halteplatten 11 verschraubt und bildet dadurch eine drehfeste Verbindung dieser Halteplatten 11.

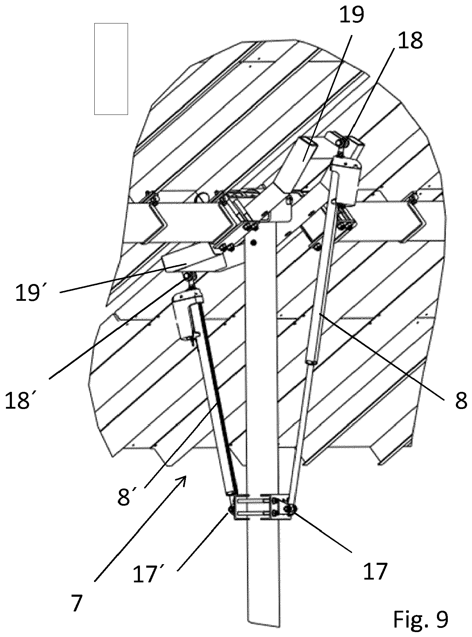

Als besonders vorteilhaft, auch im Hinblick auf die Ausführung der Erfindung nach Figur 7 hat es sich erwiesen, die Antriebseinheit 7 als Doppelantrieb mit zwei Teleskoparmen 8, 8' auszubilden. Diese Variante ist in Figur 9 als vergrößerter Ausschnitt aus Figur 7 dargestellt.

Die Antriebseinheit 7 in der Form eines doppelten Linearantriebs weist zwei über einen gemeinsamen, hier nicht dargestellten Motor gegengleich bewegbare Teleskoparme 8 und 8' auf, welche mit ihrem jeweils oberen Auge 18, 18' an den Antriebsbügeln 19, 19' angreifen. Das jeweils untere Auge 17, 17' greift an fest montierten Backen einer gemeinsamen Halterung an, welche den Schaft des Rammprofiles 9 fest umfasst. Diese vorteilhafte Ausbildung der Antriebseinheit 7 ermöglicht einen über die ganze Nachführbewegung gleichbleibenden Kraftverlauf und vermeidet damit ungünstige statische Kraftverläufe.

Der wesentliche Vorteil der Erfindung im Vergleich zum Stand der Technik liegt darin, dass durch die erfindungsgemäße Ausgestaltung der Wellenlager von mehreren benachbarten Hauptträgerwellen 4 auf einer Mehrzahl von Rammprofilen 9, die voneinander beabstandet angeordnet sind und der erfindungsgemäßen Antriebseinheit 7 es erstmals möglich wird, eine Ausrichtung von mehreren nebeneinander liegenden Solartischen 1 auch über mehrere Geländeunebenheiten anzubringen, wobei auch größere Geländestufen im Gegensatz zu herkömmlichen Anlagen, welche einen geradlinigen Verlauf der Drehachse der Solartische erfordern, wie sie aus dem Stand der Technik bekannt sind, kein Problem mehr darstellen. Das Wesen der vorliegenden Erfindung besteht somit darin, dass auch in einem gewissen Ausmaß Winkelabweichungen zwischen den einzelnen Längsachsen tolerierbar sind, ein Umstand der beim Stand der Technik bisher nicht berücksichtigt wurde, der jedoch in der Praxis häufig durch einen unebenen Geländeverlauf anzutreffen ist und bei Vorrichtungen nach dem Stand der Technik zu einem vorzeitigen Verschleiß durch unberücksichtigte Torsionskräfte auf die Trägerstruktur und/oder zu einer Überbelastung der Antriebseinheit geführt hat.

## Patentansprüche

1. Vorrichtung für die Halterung und einachsige Sonnenstandsnachführung von mehreren hintereinander angeordneten Nachführeinheiten für Solarpanele mit Antriebseinheiten (7) für diese Sonnenstandsnachführung, wobei jede Nachführeinheit ein Tragegerüst für zwei nebeneinander angeordnete Solartische (1) mit jeweils mehreren Solarpanelen (2), die auf Panelträgern (3) montiert sind, je eine zugehörige Hauptträgerwelle (4) und eine Antriebseinheit (7) aufweist, wobei jede Hauptträgerwelle (4) endständig mit je einer eine Drehwelle (10) aufweisenden Hauptträgeraufnahme (6) verbunden ist, wobei die in Reihe angeordneten Hauptträgerwellen (4) und Hauptträgeraufnahmen (6) eine Drehachse der Vorrichtung bilden, wobei mindestens eine Antriebseinheit (7) vorgesehen ist, die mit zwei unmittelbar nebeneinander liegenden Hauptträgeraufnahmen (6) gekoppelt ist, so dass eine Antriebseinheit (7) mit jeweils zwei Hauptträgerwellen (4) kommuniziert und durch Ein- oder Ausfahren eines Teleskoparms (8) die Nachführung beider Solartische (1) von Ost nach West und zurück bewirkt, und wobei benachbarte Hauptträgeraufnahmen (6) über jeweils ein Halteteil (11) an einem gemeinsamen Rammprofil (9) gestützt sind und die Antriebseinheit (7) mit dem Rammprofil (9) und den beiden Halteteilen (11) verbunden ist, **dadurch gekennzeichnet, dass** die Hauptträgeraufnahme (6) mit Bolzen (30) versehen ist, die in Ausnehmungen (28) von sich gegenüberliegenden Seitenwänden (29) eines mit dem Rammprofil (9) verbundenen Lagerwellenträgers (26) mit Spiel gelagert sind, derart, dass die benachbarten Hauptträgeraufnahmen (6) in Neigung zur Drehachse verbringbar sind.

2. Vorrichtung nach Anspruch 1, **dadurch gekennzeichnet, dass** die Hauptträgeraufnahme (6) eine mit den Bolzen (30) versehene Bolzenplatte (31) an einem Ende der Drehwelle (10), ein als Halteplatte (11) ausgebildetes Halteteil mit fest montierten Drehwellenlagerprofilen (12) im gegenüber liegenden Bereich der Drehwelle (10), eine Gegenplatte (13) und Befestigungsbolzen (14) aufweist, und dass die Hauptträgerwelle(4) zwischen der Halteplatte (11) und der Gegenplatte (13) liegt und über die Befestigungsbolzen (14) zwischen der Halteplatte (11) und der Gegenplatte (13) klemmend fixiert ist.

3. Vorrichtung nach Anspruch 2, **dadurch gekennzeichnet, dass** die Drehwelle (10) endständig an einer mit den Bolzen (30) versehenen Bolzenplatte (31) anliegt und dort linear nicht verschiebbar, jedoch drehbar gelagert ist, und dass von der Bolzenplatte (31) seitlich die Bolzen (30) hervorragen.

4. Vorrichtung nach Anspruch 3, **dadurch gekennzeichnet, dass** der Lagerwellenträger (26) zur Aufnahme der Bolzenplatte (31) ein U-Profil aufweist, dessen Schenkel von den sich gegenüber liegenden Seitenwänden (29) gebildet wird, in denen nach oben offene, U-förmige Ausnehmungen (28) sich gegenüberliegend ausgebildet sind, und dass die Bolzenplatte (31) hochkant im U-Profil derart liegt, dass die beiderseits ihrer Schmalseiten abstehenden Bolzen (30) durch die U-förmigen Ausnehmungen (28) ragen, wobei vorzugsweise ein aufgesetztes Kammblech die Bolzen (30) in den U-förmigen Ausnehmungen (28) hält.

5. Vorrichtung nach einem der vorangehenden Ansprüche 3 oder 4, **dadurch gekennzeichnet, dass** die Bolzenplatte (31) austauschbar ist.

6. Vorrichtung nach einem der vorangehenden Ansprüche 2 bis 5, **dadurch gekennzeichnet, dass** die Antriebseinheit(7) in der Form eines Linearantriebs an einem Schaft des Rammprofiles (9) befestigt ist und über einen U-förmigen Antriebsbügel (19) an den Halteplatten(11) der Drehwellen (10) zweier nebeneinander liegender Hauptträgeraufnahmen (6) angreift.

7. Vorrichtung nach einem der vorangehenden Ansprüche 2 bis 6, **dadurch gekennzeichnet, dass** ein oberes Auge (18) des Linearantriebs mit einem Antriebsbügel(19) verbunden ist, dass der Antriebsbügel (19) zumindest aus drei, bevorzugt aus fünf miteinander fest verbundenen Abschnitten (20 bis 24) besteht, die gemeinsam ein U-Profil beschreiben, wobei sich am Verbindungsarm (22) Backen (25) befinden, an denen das obere Auge (18) des Linearantriebs befestigt ist, und dass die endteiligen Abschnitte (20, 24) des Antriebsbügels (19) mit der Halteplatte (11) der Drehwelle (10) verbunden sind.

8. Vorrichtung nach einem der vorangehenden Ansprüche 6 oder 7, **dadurch gekennzeichnet, dass** eine Halteplatte (15) des Linearantriebs auf einer ersten Seite fest montierte Profile besitzt, welche eine Kontur des Rammprofiles (9) teilweise umfassen, oder Bügel aufweist, welche einen Schaft des Rammprofils (9) umfassen, und dass auf der der ersten Seite gegenüber liegenden zweiten Seite fest montierte Backen (16) vorgesehen sind, zwischen welchen ein unteres Auge (17) des Linearantriebs gelagert ist.

9. Vorrichtung nach Anspruch 8, **dadurch gekennzeichnet, dass** sich der Antriebsbügel (19) aus fünf Abschnitten (20 bis 24) zusammensetzt, wobei die endteiligen Abschnitte (20) und (24) im Winkel zur Ebene des Antriebsbügels (19) stehen.

10. Vorrichtung nach Anspruch 9, **dadurch gekennzeichnet, dass** der Winkel zwischen den endteiligen Abschnitten (20) und (24) zur Ebene des Antriebsbügels (19) etwa 15° beträgt.

11. Vorrichtung nach einem der vorangehenden Ansprüche, **dadurch gekennzeichnet, dass** der Lagerwellenträger (26) mit einem Stützschaft (27) versehen ist, der im oberen Ende des Rammprofils (9) eingeführt ist.

12. Vorrichtung nach einem der vorangehenden Ansprüche, **dadurch gekennzeichnet, dass** eine Nachführeinheit mehr als zwei Tragegerüste für Solartische (1) umfasst und die nicht mit einer Antriebseinheit (7) verbundenen Halteplatten (11) an Hauptträgerwellen (4) benachbarte Solartische (1) über einen starren Halterahmen (32) untereinander drehfest verbunden sind.

13. Vorrichtung nach einem der vorangehenden Ansprüche, **dadurch gekennzeichnet, dass** die Antriebseinheit (7) in der Form eines doppelten Linearantriebs mit einander gegenüberliegenden Teleskoparmen (8, 8') an einem Schaft des Rammprofiles (9) befestigt sind und über zwei U-förmige Antriebsbügel (19, 19') an den Halteplatten (11) der Drehwellen (10) zweier nebeneinander liegender Hauptträgeraufnahmen (6) angreifen und die beiden Teleskoparme (8, 8') von einem Antriebsmotor gegengleich angetrieben werden.

14. Vorrichtung nach einem der vorangehenden Ansprüche, **dadurch gekennzeichnet, dass** bei einem unebenen Geländeverlauf, welcher einen Knick im Verlauf der Gesamtdrehachse erfordert, die Antriebseinheit (7) nur an jenen benachbarten Halteplatten (11) von benachbarten Hauptträgeraufnahmen (6) befestigt ist, deren Längsachsen annähernd geradlinig verlaufen und die beiden Halteplatten (11) von Hauptträgeraufnahmen (6) zweier Hauptträgerwellen (4), deren Achsen einen Knick zueinander haben, keine Verbindung zum Antriebsbügel (19) einer Antriebseinheit (7) aufweist.

## Claims

1. A device for the mounting and single-axis sun position tracking of multiple tracking units arranged in succession for solar panels having drive units (7) for this sun position tracking, wherein each tracking unit has a supporting framework for two solar panel assemblies (1) arranged adjacent to one another, each having multiple solar panels (2), which are installed on panel carriers (3), an associated carrier shaft (4) and a drive unit (7) in each case, wherein each main carrier shaft (4) is connected at the ends to a main carrier receptacle (6) having a rotating shaft (10), wherein the main carrier shafts (4) and main carrier receptacles (6) arranged in series form an axis of rotation of the device, wherein at least one drive unit (7) is provided, which is coupled to the two main carrier receptacles (6) located directly adjacent to one another, and therefore a drive unit (7) communicates with two main carrier shafts (4) in each case and causes the tracking of both solar panel assemblies (1) from east to west and back by extending or retracting a telescopic arm (8), and wherein adjacent main carrier receptacles (6) are each supported via a holding part (11) on a common ram profile (9) and the drive unit (7) is connected to the ram profile (9) and the two holding parts (11), **characterised in that** the main carrier receptacle (6) is provided with bolts (30), which are mounted with play in recesses (28) of opposing side walls (29) of a bearing shaft support (26) connected to the ram profile (9), such that the adjacent main carrier receptacles (6) can be moved into inclination in relation to the axis of rotation.

2. The device according to claim 1, **characterised in that** the main carrier receptacle (6) has a bolt plate (31) provided with bolts (30) at one end of the rotating shaft (10), a holding part formed as a holding plate (11) having fixedly installed rotating shaft bearing profiles (12) in the opposing region of the rotating shaft (10), a counter plate (13), and fastening bolts (14), and the main carrier shaft (4) is located between the holding plate (11) and the counter plate (13) and is fixed by clamping via the fastening bolts (14) between the holding plate (11) and the counter plate (13).

3. The device according to claim 2, **characterised in that** the rotating shaft (10) bears at the ends on a bolt plate (31) provided with the bolts (30) and is mounted there so it is not linearly displaceable but is rotatable, and the bolts (30) protrude laterally from the bolt plate (31).

4. The device according to claim 3, **characterised in that** the bearing shaft carrier (26) has a U profile for accommodating the bolt plate (31), the legs of which are formed by the opposing side walls (29), in which U-shaped recesses (28) open on top are formed opposing one another, and the bolt plate (31) is located upright in the U profile such that the bolts (30) protruding on both sides of its narrow sides protrude through the U-shaped recesses (28), wherein preferably an applied comb plate holds the bolts (30) in the U-shaped recesses (28).

5. The device according to any one of preceding claims 3 or 4, **characterised in that** the bolt plate (31) is replaceable.

6. The device according to any one of preceding claims 2 to 5, **characterised in that** the drive unit (7) is fastened in the form of a linear drive on a shaft of the ram profile (9) and engages via a U-shaped drive bracket (19) on the holding plates (11) of the rotating shafts (10) of two adjacent main carrier receptacles (6).

7. The device according to any one of preceding claims 2 to 6, **characterised in that** an upper eye (18) of the linear drive is connected to a drive bracket (19), the drive bracket (19) consists of at least three, preferably five sections (20 to 24) fixedly connected to one another, which jointly describe a U profile, wherein jaws (25) are located on the connecting arm (22), on which the upper eye (18) of the linear drive is fastened, and the sections (20, 24) of the drive bracket (19) at the ends are connected to the holding plate (11) of the rotating shaft (10).

8. The device according to any one of preceding claims 6 or 7, **characterised in that** a holding plate (15) of the linear drive has fixedly installed profiles on a first side, which partially enclose a contour of the ram profile (9), or has brackets, which enclose a shaft of the ram profile (9), and fixedly installed jaws (16) are provided on the second side opposite to the first side, between which a lower eye (17) of the linear drive is mounted.

9. The device according to claim 8, **characterised in that** the drive bracket (19) is composed of five sections (20 to 24), wherein the sections (20) and (24) at the ends are at an angle to the plane of the drive bracket (19).

10. The device according to claim 9, **characterised in that** the angle between the sections (20) and (24) at the ends in relation to the plane of the drive bracket (19) is approximately 15°.

11. The device according to any one of the preceding claims, **characterised in that** the bearing shaft carrier (26) is provided with a support shaft (27), which is inserted into the upper end of the ram profile (9).

12. The device according to any one of the preceding claims, **characterised in that** a tracking unit comprises more than two supporting frameworks for solar panel assemblies (1) and the holding plates (11), which are not connected to a drive unit (7), on main carrier shafts (4) of adjacent solar panel assemblies (1) are connected to one another in a rotationally-fixed manner via a rigid holding frame (32).

13. The device according to any one of the preceding claims, **characterised in that** the drive unit (7) in the form of a double linear drive is fastened with opposing telescopic arms (8, 8') on a shaft of the ram profile (9) and engages via two U-shaped drive brackets (19, 19') on the holding plates (11) of the rotating shafts (10) of two adjacent main carrier receptacles (6) and the two telescopic arms (8, 8') are driven in opposite directions by a drive motor.

14. The device according to any one of the preceding claims, **characterised in that**, in the case of an uneven terrain profile, which requires a buckle in the profile of the overall axis of rotation, the drive unit (7) is only fastened on the adjacent holding plates (11) of adjacent main carrier receptacles (6), the longitudinal axes of which extend approximately linearly, and the two holding plates (11) of main carrier receptacles (6) of two main carrier shafts (4), the axes of which have a buckle in relation to one another, do not have a connection to the drive bracket (19) of a drive unit (7).

## Revendications

1. Dispositif permettant le maintien et la poursuite sur un axe de la position du soleil de plusieurs unités de poursuite montées les unes derrière les autres pour des panneaux solaires, comportant des unités d'entraînement (7) pour cette poursuite de la position du soleil, chaque unité de poursuite comportant une structure porteuse pour deux tables solaires (1) montées côte à côte ayant chacune plusieurs panneaux solaires (2) qui sont montés sur des portes panneaux (3), un arbre porteur principal associé (4) et une unité d'entraînement (7), chaque arbre porteur principal (4) étant relié à une extrémité avec un logement porteur principal (6) comportant un arbre rotatif (10) respectif, les arbres porteurs principaux (4) montés en rangées et les logements porteurs principaux (6) formant un axe de rotation du dispositif, au moins une unité d'entraînement (7) étant prévue, cette unité d'entraînement étant couplée avec deux logements porteurs principaux (6) situés directement côte à côte de sorte qu'une unité d'entraînement (7) communique avec deux arbres porteurs principaux respectifs (4), et provoque, suite au repliement ou au déploiement d'un bras télescopique (8) la poursuite des deux tables solaires (1) de l'est vers l'ouest et inversement, des logements porteurs principaux voisins (6) s'appuyant par l'intermédiaire d'une pièce de maintien (11) respective sur un profil de battage (9) commun, et l'unité d'entraînement (7) étant reliée au profil de battage (9) et aux deux pièces de maintien (11),
**caractérisé en ce que**
le logement porteur principal (6) est équipé de goujons (30) qui sont montés avec jeu dans des évidements (28) de parois latérales opposées (29) d'un support d'arbre d'appui (26) relié au profil de battage (9) de sorte que les logements porteurs principaux voisins (6) puissent être inclinés par rapport à l'axe de rotation.

2. Dispositif conforme à la revendication 1,
**caractérisé en ce que**
le logement porteur principal (6) comporte une plaque de goujons (31) équipée des goujons (30) à une extrémité de l'arbre rotatif (10), une pièce de maintien réalisée sous la forme d'une plaque de maintien (11) équipée de profilés d'appui de l'arbre rotatif (10) montés fixe dans la zone opposée de l'arbre rotatif (10), une plaque antagoniste (13) et des goujons de fixation (14), et l'arbre porteur principal (4) est positionné entre la plaque de maintien (11) et la plaque antagoniste (13) et est fixée par serrage par l'intermédiaire des goujons de fixation (14) entre la plaque de maintien (11) et la plaque antagoniste (13).

3. Dispositif conforme à la revendication 2,
**caractérisé en ce que**
l'arbre rotatif (10) s'applique à une extrémité sur la plaque de goujons (31) équipée des goujons (30) et y est montée sans pouvoir coulisser linéairement mais mobile en rotation, et les goujons (30) dépassent latéralement de la plaque de goujons (31).

4. Dispositif conforme à la revendication 3,
**caractérisé en ce que**
le support d'arbre d'appui (26) a, pour permettre la réception de la plaque de goujons (31) un profil en U dont les branches sont formées par les parois latérales opposées (29) dans lesquelles sont formés des évidements opposés (28) en forme de U se faisant face ouverts vers le haut, et la plaque de goujons (31) est située sur la tranche dans le profil en U de sorte que les goujons (30) dépassant de part et d'autre de ses petits côtés pénètrent dans les évidements (28) en forme de U, et de préférence une tôle de battage posée maintient les goujons (30) dans les évidements (28) en forme de U.

5. Dispositif conforme à l'une des revendications précédentes 3 et 4,
**caractérisé en ce que**
la plaque de goujons (31) est interchangeable.

6. Dispositif conforme à l'une des revendications précédentes 2 à 5,
**caractérisé en ce que**
l'unité d'entraînement (7) réalisée sous la forme d'un entraînement linéaire est fixée à un arbre du profil de battage (9) et vient en prise par l'intermédiaire d'un étrier d'entraînement en forme de U (19) sur les plaques de maintien (11) des arbres rotatifs (10) de deux logements porteurs principaux (6) situés côte à côte.

7. Procédé conforme à l'une des revendications 2 à 6,
**caractérisé en ce qu'**
un oeillet supérieur (18) de l'entraînement linéaire est relié à un étrier d'entraînement (19), l'étrier d'entraînement (19) est constitué d'au moins trois et de préférence de cinq segments reliés solidairement les uns aux autres (20 à 24) qui définissent conjointement un profil en U, sur le bras de liaison (22) sont positionnées des mâchoires (25) sur lesquelles est fixé l'oeillet supérieur (18) de l'entraînement linéaire, et les segments d'extrémité (20, 24) de l'étrier d'entraînement (19) sont reliés à la plaque de maintien (11) de l'arbre rotatif (10).

8. Dispositif conforme à l'une des revendications précédentes 6 et 7,
**caractérisé en ce qu'**
une plaque de maintien (15) de l'entraînement linéaire comporte sur un premier côté des profilés montés fixes qui enserrent partiellement le contour du profil de battage (9) ou comporte des étriers qui enserrent un arbre du profil de battage (9), et, il est prévu sur le premier côté situé à l'opposé du premier côté des mâchoires (16) montées fixes entre lesquelles est monté un oeillet inférieur (17) de l'entraînement linéaire.

9. Dispositif conforme à la revendication 8,
**caractérisé en ce que**
l'étrier d'entraînement (19) est constitué par l'assemblage de cinq segments (20 à 24), les segments d'extrémité (20 et 24) étant situés angulairement par rapport au plan de l'étrier d'entraînement (19).

10. Dispositif conforme à la revendication 9,
**caractérisé en ce que**
l'angle défini entre les segments d'extrémité (20 et 24) et le plan de l'étrier d'entraînement (19) est égal à environ 15°.

11. Dispositif conforme à l'une des revendications précédentes,
**caractérisé en ce que**
le support d'arbre d'appui (26) est équipé d'un arbre d'appui (27) qui est introduit à l'extrémité supérieure du profil de battage (9).

12. Dispositif conforme à l'une des revendications précédentes,
**caractérisé en ce qu'**
une unité de poursuite comporte plus de deux structures porteuses de tables solaires (1), et les plaques de maintien (11) non reliées à une unité d'entraînement (7) sont reliées solidairement en rotation les unes au-dessous des autres à des tables solaires (1) voisines d'arbres porteurs principaux (4) par l'intermédiaire d'un cadre de maintien rigide (32).

13. Dispositif conforme à l'une des revendications précédentes,
**caractérisé en ce que**
les unités d'entraînement (7) réalisées sous la forme d'un entraînement linéaire double sont fixées avec des bras télescopiques opposés (8, 8') à un arbre du profil de battage (9) et viennent en prise par l'intermédiaire de deux étriers d'entraînement en forme de U (19, 19') sur les plaques de maintien (11) des arbres rotatifs (10) de deux logements porteurs principaux (6) voisins et les deux bras télescopiques (8, 8') sont entraînés symétriquement par un moteur d'entraînement.

14. Dispositif conforme à l'une des revendications précédentes,
**caractérisé en ce que**
dans le cas d'un terrain non plan qui nécessite un coudage dans le tracé de l'axe de rotation global, l'unité d'entraînement (7) n'est fixée qu'aux plaques de maintien voisines (11) de logements porteurs principaux voisins (6) dont les axes longitudinaux s'étendent approximativement linéairement, et les deux plaques de maintien (11) de logements porteurs principaux (6) de deux arbres porteurs principaux (4) dont les axes présentent un coudage l'un par rapport à l'autre ne sont pas reliés à des étriers d'entraînement (19) d'une unité d'entraînement (7).
